# EUROPEAN PATENT APPLICATION

(11) **EP 2 418 457 A1**
(43) Date of publication of application: **15.02.2012**
(21) Application number: 10172311.2
(22) Date of filing: 09.08.2010
(51) Int. Cl.: G01B 11/06, G01B 11/24, G01B 11/27

(54) **System and method with automatic adjustment function for measuring the thickness of substrates**

(71) Applicant: Applied Materials, Inc., Santa Clara, CA 95054 (US)
(72) Inventor: Leipnitz, Thomas, 63755 Alzenau (DE)
(74) Representative: Zimmermann & Partner

(57) **Abstract**

A system for measuring the thickness of substrates in a vacuum chamber is provided. The system includes a sender (110) adapted to emit electromagnetic radiation and a receiver (120) including a multi-zone sensor (130) for detecting the electromagnetic radiation. The multi-zone sensor includes a first detection zone (132) for measuring the thickness of the substrates and a second detection zone (134) adapted to generate a signal indicative of an alignment between the sender and the receiver. The system further includes an adjustment system (140) adapted to automatically adjust the sender and the receiver with respect to each other based on the signal. Further, a method for adjustment of a sender and a receiver relative to each other is provided.

## Description

### FIELD OF THE INVENTION

Embodiments of the present invention relate to a system for measuring the thickness of substrates in a vacuum chamber. Specifically, embodiments relate to a system including a sender, a receiver and an adjustment system adapted to automatically adjust the sender and the receiver. Even more specifically, some embodiments relate to a vacuum installation including a system for measuring the thickness of substrates in a vacuum chamber of the vacuum installation, the system including the sender, receiver and adjustment system. Further embodiments relate to a method for adjusting a sender and a receiver relative to each other, and to a method for measuring the thickness of substrates in a vacuum chamber.

### BACKGROUND OF THE INVENTION

In industries such as the production of solar cells, the thickness of substrates is determined while these substrates pass through a vacuum chamber in a process line. For instance, when determining the heating power to which the substrate is to be subjected, or when determining the cooling behavior of the substrate in a cooling process, the substrate thickness is a parameter used therein. The substrate may be heated or be cooled, e.g., by active helium cooling, to avoid deviations from the desired process conditions and/or to avoid substrate defects. Presently, a point-like light source is used for the purpose of determining the substrate thickness. The light source emits light to a receiver through windows in the vacuum chamber walls. This light source is manually adjusted to emit the light to a sensor of the receiver. Substrates passing through the vacuum chamber can be detected.

However, when the point-like light source is not correctly aligned to the sensor of the receiver, reliable detection of substrate thicknesses may fail. The alignment between source and sensor may, e.g., change when source and sensor are mounted to the chamber walls, and the vacuum in the chamber is varied, leading to a deformation of the chamber walls. In such a case, it is time consuming to manually readjust the source and the sensor to improve their alignment. The production process may have to be halted, decreasing the throughput and increasing production costs.

Further, the point-like light source emits light that is diverging towards the sensor of the receiver. When a substrate is closer to the sensor, its thickness will be estimated larger because of the larger shadow it casts on the sensor as compared to when the substrate is closer to the receiver. The accuracy of the thickness measurement on a substrate may not be guaranteed when the positions of substrates in the direction between source and sensor varies.

Consequently, it is desirable to improve the measurement of substrate thicknesses and to provide a corresponding system and method.

### SUMMARY

In light of the above, according to embodiments described herein, a system for measuring the thickness of substrates in a vacuum chamber is provided. The system includes a sender adapted to emit electromagnetic radiation and a receiver including a multi-zone sensor for detecting the electromagnetic radiation. The multi-zone sensor includes a first detection zone for measuring the thickness of the substrates and a second detection zone adapted to generate a signal indicative of an alignment between the sender and the receiver. The system further includes an adjustment system adapted to automatically adjust the sender and the receiver with respect to each other based on the signal.

According to further embodiments, a method for adjustment of a sender and a receiver relative to each other is provided. The method includes emitting electromagnetic radiation from the sender to a sensor of the receiver. The sensor includes a first detection zone and a second detection zone. The method includes detecting the electromagnetic radiation on the second detection zone. The method further includes generating a signal indicative of an alignment between the sender and the receiver from the detected electromagnetic radiation on the second detection zone, and automatically adjusting the sender and the receiver with respect to each other based on the signal.

Embodiments are also directed to methods for manufacturing and operating the system for measuring the thickness of substrates in a vacuum chamber. These method steps may be performed manually or automated, e.g. controlled by a computer programmed by appropriate software, by any combination of the two or in any other manner.

Further advantages, features, aspects and details that can be combined with embodiments described herein are evident from the dependent claims, the description and the drawings.

### BRIEF DESCRIPTION OF THE DRAWINGS

So that the manner in which the above recited features of the present invention can be understood in detail, a more particular description of the invention, briefly summarized above, may be had by reference to embodiments of the invention. The accompanying drawings relate to embodiments of the invention and are described in the following:
Figs. 1-3 illustrate a method of measuring the thickness of a substrate according to embodiments described herein;
Fig. 4 illustrates a method of measuring the thickness of a substrate according to embodiments described herein;
Fig. 5 shows a system for measuring the thickness of substrates according to embodiments described herein;
Figs. 6-7 show a multi-zone sensor of a receiver according to embodiments described herein;
Fig. 8 shows a vacuum installation for processing substrates according to embodiments described herein; and
Fig. 9 shows an actuating unit of an adjustment system of the sender and/or receiver according to embodiments described herein.

### DETAILED DESCRIPTION OF THE INVENTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on, or in conjunction with, other embodiments to yield yet a further embodiment. It is intended that the present invention includes such modifications and variations.

Within the description of the drawings, the same reference numbers refer to the same components. Generally, only the differences with respect to the individual embodiments are described. Drawings need not be true to scale and features may be exaggerated for illustrational purposes.

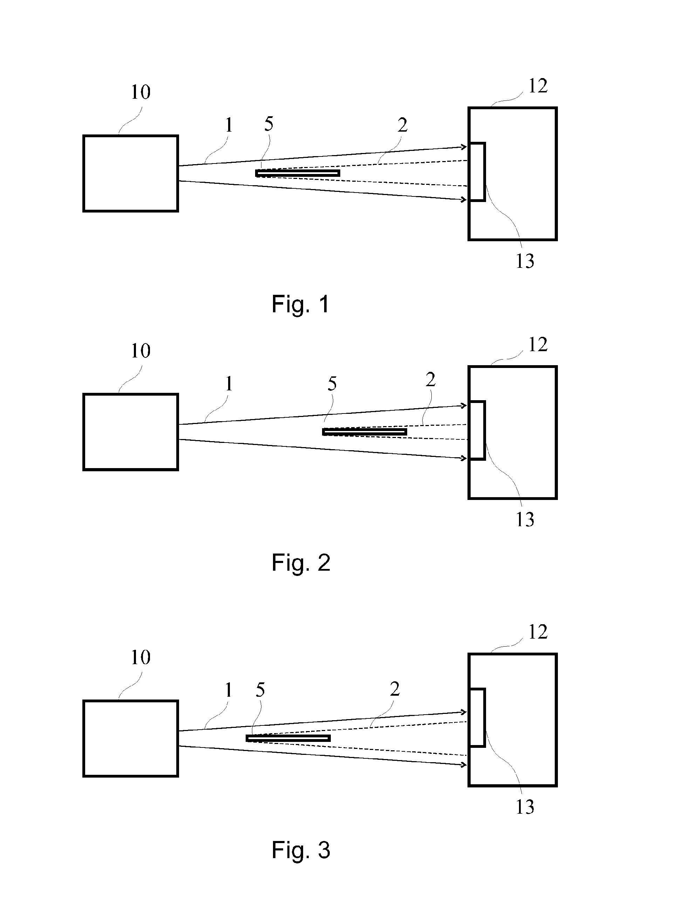

Fig. 1 shows a system for measuring the thickness of a substrate 5. A point-like light source 10 emits a light cone 1 towards the sensor 13 of a receiver 12. The substrate 5 has the direction of its thickness oriented perpendicularly to the direction between the sender and the receiver. The substrate 5 blocks part of the light 2 such that the intensity of the light is reduced on a part of the detection field of sensor 13. The width of this part on the detection field where the light is reduced correlates with the thickness of the substrate, and signals may be produced by the sensor indicating the width of the shadowed area and, hence, the thickness of the substrate.

Fig. 2 illustrates that the area with reduced light intensity on the sensor 13 does not only depend the thickness of the substrate 5, but also on its position between the light source 10 and the receiver 12. If the substrate 5 is closer to the receiver as shown in Fig. 2, then the shadowed area on the sensor 13 is smaller even if the substrate thickness is the same. Therefore, the thickness measurement in the system shown in Figs. 1 and 2 may not be reliable if the position of the substrate between source and receiver can vary.

The reliability and accuracy of the measurement of the substrate thickness may be lowered when the light source and the receiver are not well-aligned. Such a situation is illustrated in Fig. 3, where the light cone 1 and the blocked part of light 2 are partly off the detection area of the sensor 13. The measurement of the substrate thickness is inaccurate in this case since a the substrate thickness will be estimated too low from the area with reduced intensity on sensor 13, which can not take into account that the area actually blocked is larger.

Such a poor alignment may, e.g., result when the point-like light source 10 and the receiver 13 are mounted to chamber walls of a vacuum chamber through which the substrates are guided. When the pressure in the chamber is varied, this may lead to a deformation of the chamber walls and to a change in the position and/or orientation of the source 10 and receiver 13 mounted thereon, resulting in misalignment.

The source 10 may be manually re-aligned to the receiver 12, in particular to the detection area of the sensor 13. For instance, the manual alignment procedure may be carried out by varying, e.g., the position or orientation of the sensor, and determining the largest intensity value on the sensor. But this procedure can be difficult and time-consuming and may lead to downtimes of the work process and decreased throughput of processed substrates.

According to an embodiment, which can be combined with any other embodiments described herein, a sender or emitter is provided. The sender is adapted to emit a non-diverging beam of electromagnetic radiation. In particular, the sender may be adapted to emit a parallel or substantially parallel beam of electromagnetic radiation. The electromagnetic radiation may, e.g., be infrared radiation (IR radiation), ultraviolet radiation (UV radiation) or visible light. The sender may be a laser source or an IR source.

The parallelism of the beam or of the beams may, for instance, be achieved by a laser, such as a line laser, laser diodes or light emitting diodes (LEDs), possibly combined with suitable optical elements such as lenses. Multiple sources may be used, e.g., a fine grid of light emitting diodes or a light curtain, possibly combined with suitable optical elements, and a plurality of substantially parallel beams may be emitted. The sender may include more than one source of electromagnetic radiation, and may be adapted to emit electromagnetic radiation of different wavelengths. For instance, the sender may include a source of red light and a source of green light. The substantially parallel beam(s) may then consist of red and green light, either mixed or as separate beams. A higher accuracy and detection density may be achieved in this way. The sender can be adapted to emit the substantially parallel beam(s) of electromagnetic radiation at least up to a distance of 3, 4, 5 or more meters, or at least up to a distance corresponding to the diameter of a vacuum chamber for processing the substrates.

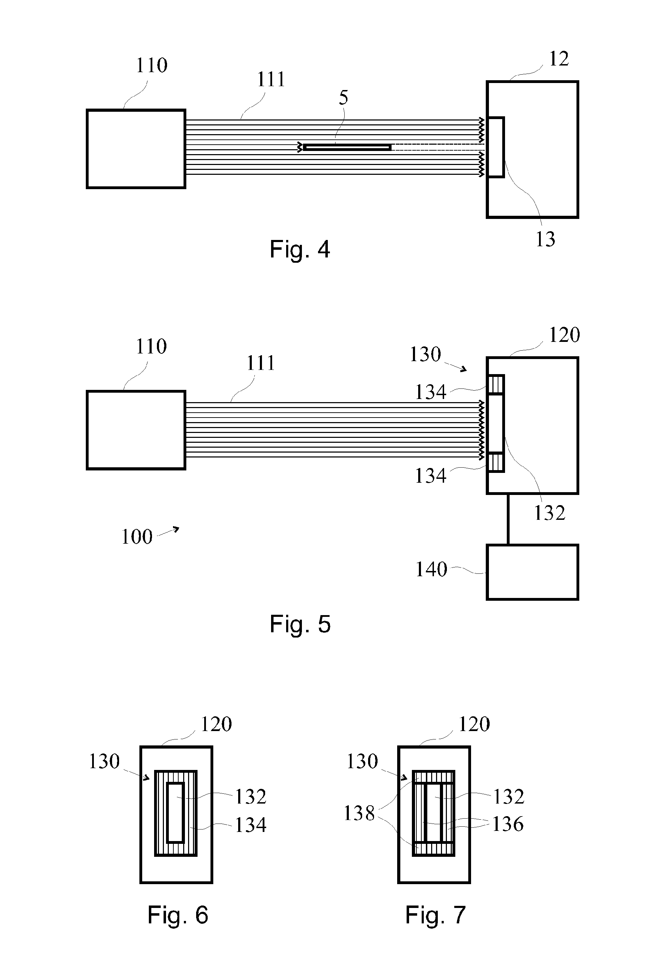

Fig. 4 shows a system for measuring the thickness of a substrate 5. The system includes a sender or emitter 110 adapted to emit a substantially parallel beam 111 of electromagnetic radiation towards a sensor 13 of a receiver 12. The substrate thickness is measured by the correlation between the substrate thickness and the area of reduced intensity of electromagnetic radiation on the sensor 13, where the substrate shadows the sensor. When using substantially parallel beams 111 of electromagnetic radiation, the position of the substrate 5 between the sender 110 and the receiver 12 does not influence the measurement of the substrate thickness. Herein, the expression "substantially parallel beam(s)" refers to a beam or beams of electromagnetic radiation whose divergence is at most so large that the position of the substrate between sender and receiver does not influence the measurement result of the thickness measurement. This depends on the desired accuracy of the thickness measurement and/or on the resolution of the sensor. For instance, a beam, or a plurality of beams, may be substantially parallel if it does not diverge more than 10⁺¹, 10⁻², 10⁻³ or even 10⁻⁴ degree, leading to a precision, for a measurement over some meters between sender and sensor, in the millimeter, sub-millimeter, micrometer or even nanometer range. A more reliable measurement of the substrate thickness is therefore achieved as compared to using point-like sources of radiation.

According to a further embodiment, which can be combined with any other embodiments described herein, a receiver is provided, typically for cooperation with a sender according to embodiments described herein. The receiver includes a first detection zone and a second detection zone. The receiver typically includes a sensor such as multi-zone sensor including the first and second detection zone. The first detection zone may be adapted for measuring the thickness of the substrates.

The second detection zone may be adapted to generate a signal indicative of an alignment between the sender and the receiver. If the area of the first detection is dimensioned such that substantially all electromagnetic radiation emitted from the sender can be collected thereon, then the alignment of the sender and the receiver is good if the second detection zone detects only marginal intensity of electromagnetic radiation. Herein, "marginal intensity" means an intensity below a specific threshold, e.g., less than 10%, less than 5% or even less than 1% of the emitted radiation. Stray light intensity may be taken into account in this way which shall not trigger a signal indicative of a poor alignment. A poor alignment is given in this case when the intensity of radiation detected on the second detection zone is above the specific threshold.

Alternatively the areas of the first detection zone and the second detection zone may be such that, even if the center of the beam(s) of electromagnetic radiation is aligned with the center of the sensor, i.e., the source is centered on the receiver, there is a certain amount of radiation on the second detection zone. The amount of this certain amount of light may, in some cases, depend on the distance between the source and the receiver. This certain amount of radiation, which is collected by the second detection zone even when the source is centered on the receiver, can be considered as an offset and is not taken into account for the determination of the quality of alignment. The specific threshold value between good and poor alignment, e.g., the threshold values as specified above, may then be taken relative to the offset value.

In some embodiments, the limit or threshold shall be in relation to the main detection area (first detection zone) and the deviation detection area (second detection zone). After a first adjustment, e.g., an operator controlled or even manual adjustment, the center of the source is aligned with the center of the receiver. This alignment may be called initial alignment. If the deviation detection, i.e., the amount of radiation detected on the second detection zone, increases to values higher than a threshold value which is relative to the detected amount at the initial alignment, the alignment is considered poor, while it is considered good if the amount of radiation detected on the second detection zone is below this relative threshold value. For instance, a relative threshold value may be a 10% deviation or less of the amount of radiation detected on the second detection zone as compared to the amount detected at initial alignment, or a 5% deviation or less, or even a 1% deviation or less. The deviation control is activated if the relative threshold is exceeded. A signal indicative of an alignment may indicate a good or poor alignment, but other qualities of alignment such as a finer gradation or a quasi-continuous scale may be devised.

The first and/or second detection zone may, e.g., be a CCD array or a corresponding part thereof. The multi-zone sensor may include a CCD array. In this case the resolution of the CCD array determines how precise the thickness of a substrate can be measured on the first detection zone and/or how finely a deviation from good alignment may be detected on the second detection zone.

Alternatively, the first and/or second detection zone may be formed by an array of photo diodes, such as a two-dimensional matrix arrangement of photo diodes. In this embodiment, the dimensions of the photo diodes and/or the separation of photo diodes determines the resolution and hence the measurement precision. Using photo diodes may have the advantage of being less expensive, while using a CCD array may have the advantage of higher accuracy of the measurements.

The first detection zone may be surrounded by the second detection zone, or at least be limited in one direction by the second detection zone. For instance, the first detection zone can be the central or core part of a two-dimensional CCD array, and the second zone a peripheral part of the CCD array circumferentially surrounding the central part. The first and/or second detection zone need not be contiguous. They may include sub-zones, e.g., 2, 4 or more than 4 sub-zones. The sensor may include more than two detection zones.

The sender and the receiver according to embodiments described herein may be included in a system for measuring the thickness of a substrate. Sender and receiver may function as a light barrier or light curtain. The system may further include an adjustment system adapted to automatically adjust the sender and the receiver with respect to each other. In particular, the system may be a self-adjusting system. The adjustment system may be adapted to receive the signal from the second detection zone of the receiver, indicating the quality of the alignment between the sender and the receiver. The adjustment system may automatically adjust the sender and the receiver with respect to each other based on the signal from the second detection zone.

The receiver may include an output port for outputting a signal from the second detection zone, and the adjustment system may be connected to this output port. The adjustment system may generate a control signal from the signal of the second detection zone of the receiver.

The adjustment system may include a first actuating unit for changing the position and/or orientation of the sender relative to the receiver, e.g., an actuating unit operatively coupled to the sender. Alternatively or additionally, the receiver may include a second actuating unit for changing the position and/or orientation of the receiver relative to the sender, e.g., an actuating unit operatively coupled to the receiver.

The first and/or second actuating units may be mechanical, preferably electromechanical actuating units. For instance, the first and/or second actuating units may include displacement mechanisms such as one or more linear axes for changing the relative position and/or orientation of sender and receiver with respect to each other. The actuating units may include tilting mechanisms. The actuating units are typically adapted to change the relative position and/or orientation of sender and receiver in at least two dimensions, more typically in three dimensions. Each actuating unit may have at least two or at least three degrees of freedom, e.g., 2, 3, 4, 5, or 6 degrees of freedom, for changing the relative position and/or orientation of sender and receiver.

The control signal may be output to the actuating unit(s) of the sender and/or the receiver for controlling an automatic alignment of the sender and the receiver with respect to each other.

Fig. 5 shows a top view on a system 100 for measuring the thickness of a substrate. The system includes a sender 110 emitting a substantially parallel beam 111 of electromagnetic radiation towards a receiver 120 of the system. The receiver 120 includes a multi-zone sensor 130 including a first detection zone 132 and a second detection zone 134. A substrate thickness can be determined by the intensity or intensity variation on the first detection zone 132 as described in the foregoing. The system 100 further includes an adjustment system 140 operatively coupled to the multi-zone sensor 130 for receiving, at least, a signal from the second detection zone 134.

On the second detection zone 134, the intensity of the impinging electromagnetic radiation is determined. For instance, as shown in Fig. 5, the parallel beam 111 of electromagnetic radiation impinge on the first detection zone 132, but also on the second detection zone 134 in the lower part shown. The signal generated from the radiation on the second detection zone 134 is received by the adjustment system 140, which computes the quality of the alignment, and, in particular, the deviations from a good alignment. The adjustment system 140 generates a control signal that is input to an actuating unit of the sender 110 and/or to an actuating unit of the receiver 120, which change the relative position and/or orientation of the sender and the receiver such that a good alignment is restored automatically. For instance, in the situation shown in Fig. 5, the sender 110 might be moved upwards in the plane of drawing to restore good alignment, such that the parallel beam 111 impinges only on the first detection zone 132.

Figs. 6 and 7 show the receiver 120 and the multi-zone sensor 130 in a frontal view in the propagation direction of the parallel beam of radiation. As compared to Fig. 5, the receiver 120 is turned by 90° to the right, i.e., clockwise. The second detection zone 134 surrounds the first detection zone 132 in Fig. 6. The first detection zone 132 is a central detection zone, and the second detection zone 134 is a peripheral detection zone. The multi-zone sensor 130 may, for instance, include one CCD array, on which the central part is used as the first detection zone and the periphery as the second detection zone.

The direction of deviation may be determined from the signal pattern of the CCD pixels. The direction may be determined from the signal collected by subzones of the second detection zone. For example, as shown in Fig. 7, the second detection zone 134 may include a first subzone 136 and a second subzone 138. The first subzone 136 is non-contiguous and is arranged adjacent to the longitudinal sides of the first detection zone 132. The second subzone 138 is non-contiguous and is arranged adjacent the lateral sides of the first detection zone 132.

A signal from the first subzone 136 may indicate a poor alignment in a direction perpendicular to the longitudinal sides of the first detection zone 132, and a signal from the second detection zone 138 may indicate a poor alignment in a direction parallel to the longitudinal sides of the first detection zone 132. Depending on which of the non-contiguous parts of the first and/or second subzone generates the measurement signal of impinging radiation, a control signal can be generated in the adjustment system to re-align the sender and the receiver relative to each other.

According to embodiments described herein, the system for measuring the thickness of substrates may include a signal processing unit for evaluating the measurement signal from the first detection zone and for determining a substrate thickness therefrom. The signal processing unit may be separate from the adjustment system.

Alternatively the part of the adjustment system processing the signal from the second detection zone and the signal processing unit may be an integrated signal processing system, e.g., a conventional computer programmed by appropriate software. The system for measuring the thickness of substrates may be adapted for simultaneously measuring a substrate thickness and automatically adjusting the sender and receiver with respect to each other. The evaluation algorithm stored in a memory portion of, e.g., the integrated signal processing system, may be adapted to discern between intensity variations caused by substrates shadowing the detection zones and intensity variations caused by alignment variations.

The distance between the sender and the receiver may, e.g., be at least 2 m, at least 3 m, at least 4 m or even at least 5 m. The beam width may, e.g., be from 10 mm to 50 mm, typically from 20 mm to 30 mm, such as 25 mm. The longitudinal dimension of the first detection zone is typically at least as large as the beam width.

In embodiments described herein, such as in those described with respect to Fig. 6, the longitudinal extension of the first detection zone is along the up-down direction of the plane of drawing. The longitudinal extension of the first detection zone may, e.g., be in the range from 10 mm to 50 mm, typically from 20 mm to 30 mm, such as 25 mm. The lateral extension of the first detection zone (in left-right direction in Fig. 6) may, e.g., be in the range from 1 mm to 20 mm, typically from 2 mm to 10 mm, such as 5 mm. The longitudinal and lateral dimensions of the first detection zone may be such that the first detection zone can receive 100% of the radiation emitted from the sender.

The second detection zone may, e.g., have a relative width of from 1 mm to 20 mm, typically from 2 mm to 10 mm, such as 5 mm, as measured outward from the first detection zone. The absolute length of the second detection zone may be in the range from 10 mm to 70 mm, typically from 20 mm to 40 mm, such as 30 mm, and the absolute width may be in the range from 2 mm to 40 mm, typically from 5 mm to 20 mm, such as 10 mm.

According to embodiments, a vacuum installation for processing substrates is provided. The vacuum installation includes a vacuum chamber. The vacuum installation may include a system for measuring the thickness of substrates according to any of the embodiments described herein. The sender and/or the receiver may be arranged in the vacuum chamber. However, typically the process components in the vacuum chamber are kept to a minimum to avoid deterioration of the vacuum, e.g., by outgassing from the components.

In typical embodiments, the vacuum chamber includes at least one chamber wall with a window, typically two opposing chamber walls with respective first and second windows. The window or the windows are made from a material transmitting the electromagnetic radiation, e.g., glass, quartz glass, plastics, and combinations thereof. The choice of materials may depend on the process application within the vacuum chamber. The thickness of the materials may depend on the window size and/or the pressure difference between the vacuum in the chamber and the outside atmospheric pressure. The sender may be arranged to emit electromagnetic radiation through a window towards the receiver. Typically, the sender is arranged to emit the electromagnetic radiation through a first and a second window in respective chamber walls towards the receiver.

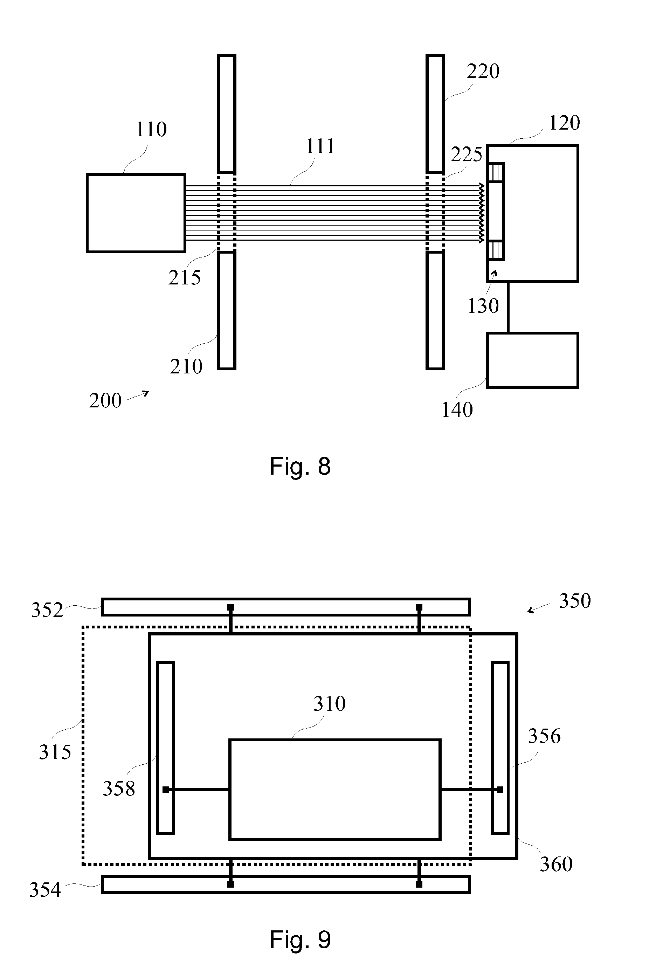

Fig. 8 shows a vacuum installation 200 including a first chamber wall 210 with a first window 215, and a second chamber wall 220 with a second window 225 according to embodiments. The vacuum installation 200 further includes a system as described with respect to Fig. 5. The sender 110 emits a (substantially) parallel beam 111 of electromagnetic radiation through the first and second windows towards the multi-zone detector 130 of receiver 120.

The sender and/or the receiver may be mounted on a chamber wall. Typically, an actuating unit of the sender and/or an actuating unit of the receiver is mounted on a chamber wall. The sender and/or receiver may be mounted or otherwise operatively coupled to the respective actuating unit.

Fig. 9 schematically illustrates an actuating unit 350 of the adjustment system according to embodiments. The actuating unit 350 serves to position the component 310, which may, e.g., be the sender 110 or the receiver 120, with respect to a window 315, which may, e.g., be the first window 215 or the second window 225, and with respect to the counterpart of the component 310, e.g. the receiver 120 or sender 110. The actuating unit 350 includes a first set of linear axes 352, 354, which are mounted on a chamber wall (not shown). A frame 360 can be moved in a first adjustment direction defined by the first set of linear axes 352 and 354. The actuating unit 350 includes a second set of linear axes 356, 358 mounted on the frame 360. The component 310 can be moved in a second adjustment direction defined by the second set of linear axes 356, 358. The second adjustment direction is independent of the first, e.g., perpendicular thereto as shown in Fig. 9. The position of the component 310 can therefore be adjusted in two dimensions, based on the control signal provided by the adjustment system, which is computed from the measurement signals of the second detection zone.

There may be further linear axes in a third adjustment direction, e.g., perpendicular to the plane of drawing in Fig. 9. The first, second and/or third adjustment direction may be perpendicular or, at least, linearly independent directions. Further, the actuating unit may include a tilting mechanism, which may tilt the component about at least one, at least two or three independent tilting axes for adjusting the orientation of the component. The more degrees of freedom the actuating unit has, the more flexible it is to align the component 310 with its counterpart. However, the control algorithm becomes more complex when the number of degrees of freedom is increased. A desired balance between flexibility and complexity may be provided.

When the pressure in the vacuum chamber is varied, the chamber walls may be deformed. For example, when the chamber pressure in the vacuum chamber is changed from atmospheric pressure to a vacuum state, e.g. to pressure not greater than 50 hPa, the chamber walls may bend inwardly into the vacuum chamber. A sender and/or receiver which is directly or indirectly mounted to such a deformed chamber wall may lose a good alignment with its counterpart. Measurement errors in the measurement of substrate thicknesses may result, possibly leading to an error in the production process and to production loss.

Good alignment can be automatically restored by the system according to embodiments described herein. The automatic adjustment of the sender and the receiver by the system also improves and speeds up the first installation of the components and their first alignment. The re-adjustment and re-alignment may be carried out continuously by the system, reducing the risk of erroneous measurements. No interference by an operator or maintenance personnel is needed.

Embodiments are not limited to vacuum installations. Further embodiments relate to substrate detection and/or measurement, e.g., on tables such as transport tables. These may be used under atmospheric pressure. The system according to embodiments described herein may be part of such tables and automatically adjust sender and receiver if, e.g., vibrations or thermal expansion of the tables occur, leading to drift and poor alignment.

According to further embodiments, a method for adjustment of a sender and a receiver relative to each other is provided. The method may include emitting electromagnetic radiation from the sender to a first detection zone and/or a second detection zone of a receiver. The method may include emitting electromagnetic radiation from the sender to a sensor of the receiver, e.g. a multi-zone sensor as described herein. The sensor may include a first detection zone and a second detection zone. The first detection zone may be surrounded by the second detection zone. The second detection zone may include at least one first subzone and at least one second subzone.

Emitting the electromagnetic radiation may include emitting a parallel beam or parallel beams of electromagnetic radiation from the sender to the receiver, or emitting substantially parallel beam(s). Emitting the electromagnetic radiation may include emitting the electromagnetic radiation from the sender to the receiver through a first window in a first wall of a vacuum chamber, typically through the first window in the first wall and through a second window in a second wall of the vacuum chamber. The method may include changing the pressure in the vacuum chamber.

The method includes detecting the electromagnetic radiation on the second detection zone. The method further includes generating a signal indicative of an alignment between the sender and the receiver from the detected electromagnetic radiation on the second detection zone. Generating the signal may include computing the alignment between the sender and the receiver from the intensity of the electromagnetic radiation detected on the second detection zone.

In some embodiments, generating the signal may include generating a first signal indicative of an alignment between the sender and the receiver in a first direction from the electromagnetic radiation detected on the at least one first subzone and/or generating a second signal indicative of an alignment between the sender and the receiver in a second direction from the electromagnetic radiation detected on the at least one second subzone. Alternatively or additionally, generating the signal may include generating the signal based on a threshold intensity value, such as a threshold intensity value indicative of good alignment if the signal intensity value is below the threshold value and indicative of a poor alignment if the signal intensity value is above the threshold value.

The method further includes automatically adjusting the sender and the receiver with respect to each other based on the signal. Automatically adjusting may include re-aligning the sender and the receiver with respect to each other. In some embodiments, automatically adjusting may include changing the relative position and/or orientation of the sender and the receiver. Additionally or alternatively, automatically adjusting may include re-aligning the sender and the receiver with respect to each other when the first chamber wall is deformed by a changing pressure in the vacuum chamber. Therein, the first and second chamber walls may be deformed by the changing pressure in the vacuum chamber.

Further, automatically adjusting may optionally include comparing an intensity value of the signal with a threshold value, and performing automatic adjustment if the signal intensity value is above the threshold value. In some embodiments, no adjustment is performed when the signal intensity value is below the threshold value.

The emitted radiation power of the sender may decrease over time due to an aging process of the radiation source. The detection efficacy of the sensor may decrease in addition or in the alternative. This may lead to the situation where the radiation detected on the second detection zone is below the threshold that indicates poor alignment, and no automatic adjustment is triggered although there actually is poor alignment.

According to some embodiments, the method may further include determining the total light intensity received by the sensor. This may include adding the intensities received on the first and second detection zone. Further, the method may include storing a first value of the total light intensity, e.g., in a memory of the signal processing unit or integrated signal processing system according to embodiments described herein.

The method may further include determining a second value of the total light intensity detected by the sensor, in particular at a different point in time, and comparing the first and the second value. Additionally, the method may further include adjusting the threshold value based on the comparison of the first and the second value. In this way, the effect of aging of the components may be compensated and the lifetime of the system be increased, leading to reduction of production costs.

According to a further embodiment, a method for measuring the thickness of substrates in a vacuum chamber is provided. The method includes the method for adjustment of a sender and a receiver relative to each other according to any of the embodiments described herein, wherein emitting the electromagnetic radiation comprises emitting substantially parallel beams of electromagnetic radiation. The method for measuring the thickness of substrates further includes detecting the electromagnetic radiation on the first detection zone and generating a measurement signal indicative of the substrate thickness from the detected electromagnetic radiation on the first detection zone.

While the foregoing is directed to embodiments of the invention, other and further embodiments of the invention may be devised without departing from the basic scope thereof, and the scope thereof is determined by the claims that follow.

## Claims

1. A system (100) for measuring the thickness of substrates in a vacuum chamber, the system comprising:
a sender (110) adapted to emit electromagnetic radiation;
a receiver (120) comprising a multi-zone sensor (130) for detecting the electromagnetic radiation,
the multi-zone sensor comprising:
a first detection zone (132) for measuring the thickness of the substrates and
a second detection zone (134) adapted to generate a signal indicative of an alignment between the sender and the receiver; and
an adjustment system (140) adapted to automatically adjust the sender and the receiver with respect to each other based on the signal.

2. The system according to claim 1, wherein the first detection zone is surrounded by the second detection zone.

3. The system according to any of the preceding claims, wherein the second detection zone comprises at least one first subzone (136) and at least one second subzone (138), wherein the first subzone is adapted to generate a first signal indicative of an alignment between the sender and the receiver in a first direction, and the second subzone is adapted to generate a second signal indicative of an alignment between the sender and the receiver in a second direction.

4. The system according to any of the preceding claims, wherein at least one component, chosen from the sender and the receiver, comprises an electromechanical or mechanical actuating unit, typically including at least one electromechanically or mechanically actuated linear axis.

5. The system according to any of the preceding claims, wherein the sender and the receiver have a distance of at least 2 m, typically of at least 3 m, with respect to each other.

6. The system according to any of the preceding claims, wherein the sender is adapted to emit substantially parallel beams (111) of electromagnetic radiation to the multi-zone sensor for measuring the thickness of the substrates on the first detection zone.

7. A vacuum installation for processing substrates, comprising:
a vacuum chamber including a first chamber wall with a first window; and
the system according to any of the preceding claims, wherein the sender is arranged to emit the electromagnetic radiation through the first window towards the receiver.

8. The vacuum installation according to claim 7, wherein the adjustment system is adapted to automatically re-align the sender and the receiver with respect to each other when the first chamber wall is deformed by a changing pressure in the vacuum chamber.

9. A method for adjustment of a sender (110) and a receiver (120) relative to each other, the method comprising:
emitting electromagnetic radiation from the sender to a sensor (130) of the receiver, the sensor comprising a first detection zone (132) and a second detection zone (134);
detecting the electromagnetic radiation on the second detection zone;
generating a signal indicative of an alignment between the sender and the receiver from the detected electromagnetic radiation on the second detection zone; and
automatically adjusting the sender and the receiver with respect to each other based on the signal.

10. The method according to claim 9, wherein the first detection zone is surrounded by the second detection zone, and wherein generating the signal comprises computing the alignment between the sender and the receiver from the intensity of the electromagnetic radiation detected on the second detection zone.

11. The method according to any of the claims 9 to 10, wherein the second detection zone comprises at least one first subzone (136) and at least one second subzone (138), and wherein generating the signal comprises:
generating a first signal indicative of an alignment between the sender and the receiver in a first direction from the electromagnetic radiation detected on the at least one first subzone and/or generating a second signal indicative of an alignment between the sender and the receiver in a second direction from the electromagnetic radiation detected on the at least one second subzone.

12. The method according to any of the claims 9 to 11, wherein emitting the electromagnetic radiation comprises:
emitting the electromagnetic radiation from the sender through a first window in a first wall of a vacuum chamber to the receiver.

13. The method according to claim 12, comprising:
changing the pressure in the vacuum chamber;
and wherein automatically adjusting the sender and the receiver with respect to each other comprises:
re-aligning the sender and the receiver with respect to each other when the first chamber wall is deformed by a changing pressure in the vacuum chamber.

14. The method according to any of the claims 9 to 13, wherein automatically adjusting the sender and the receiver with respect to each other comprises:
changing the relative position and/or orientation of the sender and the receiver.

15. A method for measuring the thickness of substrates in a vacuum chamber, the method comprising:
the method for adjustment of a sender and a receiver relative to each other according to any of the claims 9 to 14, wherein emitting the electromagnetic radiation comprises emitting a substantially parallel beam (111) of electromagnetic radiation; and
detecting the electromagnetic radiation on the first detection zone and generating a measurement signal indicative of the substrate thickness from the detected electromagnetic radiation on the first detection zone.

## Amended claims

### Amended claims in accordance with Rule 137(2) EPC.

**1.** A system (100) for measuring the thickness of substrates (5) in a vacuum chamber (200), the system comprising:
a sender (110) adapted to emit substantially parallel beams (111) of electromagnetic radiation;
a receiver (120) comprising a multi-zone sensor (130) for detecting the electromagnetic radiation,
the multi-zone sensor comprising:
a first detection zone (132) adapted to generate a measurement signal for measuring the thickness of the substrates and
a second detection zone (134) adapted to generate a signal indicative of an alignment between the sender and the receiver; and
an adjustment system (140) adapted to adjust the sender and the receiver with respect to each other based on the signal from the second detection zone; and
a signal processing unit for evaluating the measurement signal form the first detection zone and for determining the substrate thickness therefrom.

**2.** The system according to claim 1, wherein the first detection zone is surrounded by the second detection zone.

**3.** The system according to any of the preceding claims, wherein the second detection zone comprises at least one first subzone (136) and at least one second subzone (138), wherein the first subzone is adapted to generate a first signal indicative of an alignment between the sender and the receiver in a first direction, and the second subzone is adapted to generate a second signal indicative of an alignment between the sender and the receiver in a second direction.

**4.** The system according to any of the preceding claims, wherein at least one component, chosen from the sender and the receiver, comprises an electromechanical or mechanical actuating unit, typically including at least one electromechanically or mechanically actuated linear axis.

**5.** The system according to any of the preceding claims, wherein the sender and the receiver have a distance of at least 2 m, typically of at least 3 m, with respect to each other.

**6.** The system according to any of the preceding claims, wherein the adjustment system and the signal processing unit are an integrated signal processing system.

**7.** A vacuum installation (200) for processing substrates (5), comprising:
a vacuum chamber including a first chamber wall (210) with a first window (215); and
the system according to any of the preceding claims, wherein the sender is arranged to emit the electromagnetic radiation through the first window towards the receiver.

**8.** The vacuum installation according to claim 7, wherein the adjustment system is adapted to automatically re-align the sender and the receiver with respect to each other when the first chamber wall is deformed by a changing pressure in the vacuum chamber.

**9.** A method for measuring the thickness of substrates (5) in a vacuum chamber (200) including a method for adjustment of a sender (110) and a receiver (120) relative to each other, the method comprising:
emitting a substantially parallel beam (111) of electromagnetic radiation from the sender to a sensor (130) of the receiver, the sensor comprising a first detection zone (132) and a second detection zone (134);
detecting the electromagnetic radiation on the second detection zone;
generating a signal indicative of an alignment between the sender and the receiver from the detected electromagnetic radiation on the second detection zone;
adjusting the sender and the receiver with respect to each other based on the signal; and
detecting the electromagnetic radiation on the first detection zone and generating a measurement signal indicative of the substrate thickness from the detected electromagnetic radiation on the first detection zone.

**10.** The method according to claim 9, wherein the first detection zone is surrounded by the second detection zone, and wherein generating the signal comprises computing the alignment between the sender and the receiver from the intensity of the electromagnetic radiation detected on the second detection zone.

**11.** The method according to any of the claims 9 to 10, wherein the second detection zone comprises at least one first subzone (136) and at least one second subzone (138), and wherein generating the signal comprises:
generating a first signal indicative of an alignment between the sender and the receiver in a first direction from the electromagnetic radiation detected on the at least one first subzone and/or generating a second signal indicative of an alignment between the sender and the receiver in a second direction from the electromagnetic radiation detected on the at least one second subzone.

**12.** The method according to any of the claims 9 to 11, wherein emitting the electromagnetic radiation comprises:
emitting the electromagnetic radiation from the sender through a first window in a first wall of a vacuum chamber to the receiver.

**13.** The method according to claim 12, comprising:
changing the pressure in the vacuum chamber;
and wherein automatically adjusting the sender and the receiver with respect to each other comprises:
re-aligning the sender and the receiver with respect to each other when the first chamber wall is deformed by a changing pressure in the vacuum chamber.

**14.** The method according to any of the claims 9 to 13, wherein automatically adjusting the sender and the receiver with respect to each other comprises:
changing the relative position and/or orientation of the sender and the receiver.
